# EUROPEAN PATENT APPLICATION

(11) **EP 2 120 092 A1**
(43) Date of publication of application: **18.11.2009**
(21) Application number: 09160030.4
(22) Date of filing: 12.05.2009
(51) Int. Cl.: G03F 1/14

(54) **Pellicle**

(30) Priority: 14.05.2008 JP 2008127102
(71) Applicant: Shin-Etsu Chemical Co., Ltd., Tokyo (JP)
(72) Inventor: Shirasaki, Toru, Gunma-Ken (JP)
(74) Representative: Peaucelle, Chantal

(57) **Abstract**

A pellicle used in semiconductor lithography is provided and comprises a pellicle frame made of aluminum or an aluminum alloy. The surface of the frame is free of pigment.

## Description

### Field of the Invention

The present invention relates to a lithographic pellicle or, in particular, to a lithographic pellicle used to protect from dirt in the manufacture of semiconductor devices such as an LSI and a ULSI. More particularly, the invention relates to a lithographic pellicle used for ultraviolet exposure of 200 nm or shorter wavelengths, which is employed in exposure where high resolution is required.

### Background Art

Conventionally, manufacturing of semiconductor devices such as an LSI and a ULSI or liquid crystal display panels, etc., involves rradiating semiconductor wafers or liquid crystal base plates with light for patterning. However, the foregoings have a problem in that when dirt is deposited on an exposure base plate used in such cases, this dirt absorbs and reflects the light, and thus, the transferred patterning is deformed and the edge is roughened, thereby degrading the dimension, quality, and appearance, and as a result, the performance of the semiconductor device, the liquid crystal display plate, etc., the manufacturing yield is lowered.

Therefore, these tasks are usually performed in a clean room, but it is difficult to keep all the time the exposure base plate in a good condition even inside the clean room, and hence, there is often performed a method of adhering a pellicle that has good transmission to the exposure light on the surface of the exposure base plate to protect from dirt.
In this case, there is an advantage in that the dirt is not deposited directly on the surface of the exposure base plate, but is deposited on the pellicle film, so that during lithography, the dirt on the pellicle exerts no influence on the transfer, provided that the focus is set onto the pattern of the exposure base plate.

This pellicle is so configured that a good solvent of a transparent pellicle film being formed from nitrocellulose, cellulose acetate, etc., and having good light transmission is applied onto the upper portion of a pellicle framework made of aluminum, stainless steel, polyethylene, etc., then the film is dried to become bonded to the pellicle framework (see JP-A-S58-219023); alternatively, the pellicle film can be bonded using a bonding agent such as an acrylic resin and an epoxy resin (see U.S. Pat. No. 4861402, JP-B-S63-27707, and JP-A-H7-168345), and while to the underside of the pellicle framework is bonded an adhesive layer comprising a polybutene resin, a polyvinyl acetate resin, an acrylic resin, a silicone resin, etc., and a release layer (separator) for temporarily protecting the adhesive layer.

In the recent years, lithography resolutions are gradually increasing, and therefore, to realize that resolution, light with a shorter wavelength slowly becomes used as a light source. Specifically, the light is ultraviolet light, and there is a shift from g-line (436 nm) to i-line (365 nm) and further to KrF excimer lasers (248 nm), while the use of ArF excimer lasers (193 nm) has recently begun.
Thus, the light with a short wavelength has large light energy; therefore, it has become difficult to secure sufficient light resistance in a film material of the conventional cellulose type. For this reason, subsequent to the KrF excimer laser, a transparent fluororesin has been used for the film material.

If a photomask is used for a long period of time, a foreign substance precipitates on the photomask surface, which may deteriorate the pattern. This is due to the fact that a gas element in the air reacts, becomes solid on the photomask surface, and the solid grows to a growing foreign substance (Haze) that is printed. Furthermore, residual ions or residual organic elements on the photomask surface may react to grow into a foreign substance. In particular, in the case of exposure using light with short wavelengths such as KrF or ArF, there are many substances that absorb the short wavelength light; therefore, these substances absorb the light during the exposure and become activated, accelerating the generation of the foreign substance.

Therefore, in an environment in which a semiconductor exposure step is performed, the occurrence of the growing foreign substance is restrained by controlling the concentration of ions in the air or the concentration of organic elements.
Also, in particular, in the exposure using ArF, ammonium sulphate is often generated as the growing foreign substance. Generally, sulfuric acid or ammonia has been used in a photomask cleaning step during the photomask manufacturing step, but if the agents reside on the surface of the photomask, the growing foreign substance may occur from the residues during the subsequent exposure step. Therefore, in the photomask cleaning step, there is a move to limit the use of sulfuric acid or ammonia, and instead, the use of, for example, cleaning with ozone water has begun (see JP-A-2001-96241).

Meanwhile, with respect to the pellicle, an aluminum alloy generally is used for the pellicle frame. Some anodization, for example, black alumite processing, is performed on the surface of that aluminum frame. Generally, sulfuric acid is used in the alumite processing; therefore, sulfuric acid is detected from such a pellicle frame. Also, when acids other than sulfuric acid are used in the alumite processing, the substitute acids are left in the alumite layer.
Thus, in the case of the pellicle frame on which the alumite processing is performed, acids such as sulfuric acid reside in the alumite layer, and the residual acid element may be the cause of the growing foreign substance on the photomask when the pellicle is pasted to the photomask.

Further, in the black alumite processing, azo dye generally is used as a black dye. Ammonium ion may be detected as an impurity from the azo dye. This ammonium ion also has a high possibility of being the cause of ammonium sulphate, which represents the growing foreign substance. Thus, if the ion is analyzed in frames on which the black alumite processing has been performed, the sulfate ion and ammonium ion will be detected. This will pose a problem when restraining the growing foreign substance of the ammonium sulfate.

### Summary of Invention

### Technical Problem

In consideration of the circumstances such as those recited above, the present invention is directed to provide a pellicle frame that does not contain any substance causing a growing foreign substance.

### Solution to Problem

A first aspect in accordance with the present invention provides a pellicle used in semiconductor lithography, comprising a pellicle frame made of aluminum or an aluminum alloy, wherein the surface of the frame is free of pigment. In accordance with an additional mode of the invention, the surface of the frame is free of acid and/or ammonium ion, and can be polished or not polished.
A second aspect in accordance with the present invention provides a method of making a pellicle frame, comprising steps of shaping a frame out of aluminum or an aluminum alloy and smoothing the surface of the frame, while skipping steps of pigmenting, for example, anodic coating.

### Advantageous Effect of Invention

According to the pellicle of the present invention, instead of performing processing, such as black alumite processing, which may cause acid elements or ions that result in a growing foreign substance; for a pellicle frame, only shape machining is performed and a colorless aluminum or aluminum alloy is used, or only polishing is performed as surface processing after the shape machining and a colorless aluminum or aluminum alloy is used. This eliminates the possibility of the presence of these acid or ammonium elements on the frame surface, and the advantage is in that a very clean pellicle (in terms of ions) can be provided.

### Description of Embodiments

The inventor discovered that when aluminum not processed with surface processing containing ions is used for a pellicle frame, the above-mentioned trouble could be avoided.
As explained above, in the currently used pellicle frames, an aluminum frame surface is processed with some anodization, for example, black alumite processing. The acid element used during alumite processing resides in an alumite layer, and furthermore, an ammonium element of a black dye included in the alumite layer is also present. When the pellicle is attached to a photomask and used for a long period of time, these elements may become the cause of a growing foreign substance on a photomask surface.

However, when colorless aluminum or aluminum alloy not processed with such black alumite processing, etc., is used as a machining raw material for molding processing, or when polishing only is performed, as surface processing, on the pellicle frame after the molding processing, this eliminates the possibility of the presence of these acid or ammonium elements on the frame surface, and a very clean pellicle (in terms of ions) can be provided.

### Examples

Hereinafter, examples of the present invention are described. Example 1
A 5% solution of Cytop CTX-S (manufactured by Asahi Glass Co., Ltd.) dissolved in perfluorotributylamine was dropped onto a silicon wafer and spread on the wafer by spin coating, rotating the wafer at 830 rpm. Then, drying was performed at room temperature for 30 minutes, after which further drying was performed at 180°C, thus forming a uniform film. An aluminum frame applied with a bonding agent was affixed thereupon, and only the film was peeled off, thus forming a pellicle film.
A pellicle frame was manufactured of aluminum with outer dimensions of 149 mm x 122 mm x 5.8 mm. For this pellicle frame, colorless aluminum processed only with shape machining was used.

One end face of the pellicle frame was applied with a photomask adhesive, and another end face was applied with a film bonding agent. Then, the film bonding agent side was affixed to the pellicle film extracted to the aluminum frame, and the film of the outer circumference of the pellicle frame was trimmed, thus completing the pellicle.
The completed pellicle was put into a polypropylene bag and 100 ml of purified water was poured so that the pellicle was completely immersed. The bag was heat-sealed and then heated for one hour at 80°C. When the extracted water was analyzed with an ion chromatogram, the sulfate ion or other acid ions were not detected. Furthermore, ammonium ion was not detected, either.

### Comparative Example 1

A 5% solution of Cytop CTX-S (manufactured by Asahi Glass Co., Ltd.) dissolved in perfluorotributylamine was dropped onto a silicon wafer, and spread on the wafer by spin coating, rotating the wafer at 830 rpm. Then, drying was performed at room temperature for 30 minutes, after which further drying was performed at 180°C, thus forming a uniform film. An aluminum frame applied with a bonding agent was affixed thereupon, and only the film was peeled off, thus forming a pellicle film.
A pellicle frame was manufactured of aluminum with outer dimensions of 149 mm x 122 mm x 5.8 mm. This pellicle frame had been processed with surface processing of black alumite.

One end face of the pellicle frame was applied with a photomask adhesive, and another end face was applied with a film bonding agent. Then, the film bonding agent side was affixed to the pellicle film extracted to an aluminum frame, and the film of the outer circumference of the pellicle frame was trimmed, thus completing the pellicle.
The completed pellicle was put into a polypropylene bag and 100 ml of purified water was poured so that the pellicle was completely immersed. The bag was heat-sealed and then heated for one hour at 80°C. When the extracted water was analyzed with an ion chromatogram, 0.1-ppm sulfate ion and 0.1-ppm ammonium ion were detected.

## Claims

1. A pellicle used in semiconductor lithography, comprising a pellicle frame made of aluminum or an aluminum alloy, wherein the surface of the frame is free of pigment.

2. A pellicle of claim 1, wherein the surface of the frame is further free of acid.

3. A pellicle of claim 1, wherein the surface of the frame is further free of ammonium ion.

4. A pellicle of claim 1, wherein the surface of the frame is free of acid and ammonium ion.

5. A pellicle of claim 1, 2, 3 or 4, wherein the surface of the frame is polished.

6. A pellicle of claim 1, 2, 3 or 4, wherein the surface of the frame is not polished.

7. A method of making a pellicle frame, comprising steps of shaping a frame out of aluminum or an aluminum alloy and smoothing the surface of the frame, while skipping steps of pigmenting.

8. A method of claim 7, wherein anodic coating is skipped.
